# NEUE EUROPÄISCHE PATENTSCHRIFT

(11) **EP 0 677 926 B2**
(45) Veröffentlichungstag und Bekanntmachung des Hinweises auf die Entscheidung über den Einspruch: **20.06.2001**
(45) Hinweis auf die Patenterteilung: 15.07.1998
(21) Anmeldenummer: 95250031.2
(22) Anmeldetag: 08.02.1995
(51) Int. Cl.: H03K 17/97

(54) **Schaltgerät für Handbetätigung und die Umwandlung eines Betätigungsweges in ein elektrisches Signal**
Manually operated switching device and transformation of a distance moved in an electrical signal
Boîte de manoeuvre pour commande manuelle et transformation d'une étape de commande en signal électrique

(30) Priorität: 11.04.1994 DE 4412557
(43) Veröffentlichungstag der Anmeldung: 18.10.1995
(73) Patentinhaber: MANNESMANN Aktiengesellschaft, 40213 Düsseldorf (DE)
(72) Erfinder: Freitag, Holger, D-44388 Bochum (DE); Krebs, Wolfgang, D-58300 Wetter (DE)
(74) Vertreter: Presting, Hans-Joachim, Dipl.-Ing.

(56) Entgegenhaltungen:
- DE-C- 1 912 401
- US-A- 4 054 860
- US-A- 4 061 988
- US-A- 5 120 912
- Prospektblätter LH12 'Hängesteuertafeln HT1/HT2' Fa.W.Gessmann GmbH
- Prospektblätter LH11 'Potentiometer- und Stufendrucktaster' Fa. W.Gessmann GmbH
- Sammelkatalog 1993 Fa.Télémécanique/Groupe Schneider Katalog KSK, Seiten 5/161-5/163 'Drucktaster mit Analogausgang'

## Beschreibung

Die Erfindung betrifft ein Schaltgerät gemäß dem Oberbegriff des Anspruchs 1.

Ein solches gerät ist aus dem Katalog der Fa. Gessmaur " Häugesteuertsfilm HT1 und HT2" (LH11 und LH12) aus dem Jala 1982 bekannt.

Es sind u.a. optische Analogtaster (Bauart Demag Nr. 46939844) bekannt, bei denen ein besonderer Abgleich für das Tastsignal erforderlich ist und die derartige Abmessungen aufweisen, daß eine Integration in Hand-schalter (wie z.B. in den Demag-Manulift) nur unter Schwierigkeiten erfolgen kann.

Aus der US 5,120,912 ist zwar kein gattungsgemäßer Schalter, sondern ein Membranschalter mit in Serie geschalteten Widerständen bekannt. Dieser bekannte Membranschalter bedient sich auf der Grundlage einer Maschinenbetätigung für die Umwandlung eines Betätigungsweges eines gefederten Kontaktelementes, das jedoch nicht aus Schaltkontakten üblicher Bauart, sondern aus einem federnden Schleifkontakt besteht, der durch seine wegabhängige örtliche Lage auf verschiedenen Widerstandsschichten unterschiedliche Widerstandswerte erzeugt. Der Membranschalter ist daher zum Abgleich von Spannungen, die in Brückenschaltungen auftreten, geeignet, hingegen nicht als Schaltgerät für Handbetätigung und die Umwandlung eines Betätigungsweges in ein elektrisches Signal in Verbindung mit einer stufenlosen Steuerung für fördertechnische Antriebe, Fahrantriebe, Hubantriebe, Kettenzüge, Schwenkantriebe u.dgl. mit einem Gehäuse für die Bildung von Schaltkontakten mittels gefederter Kontaktelemente.

Die Aufgabe der vorliegenden Erfindung besteht darin, eine Stufenvorgabe durch eine stufenlose Vorgabe zu ersetzen und den Taster kleiner zu bauen und mit einer größeren Anzahl von Funktionen zu versehen.

Die gestellte Aufgabe wird erfindungsgemäß entsprechend der Merkmale des Anspruchs 1 gelöst. Außerdem kann der Taster sehr klein gebaut werden. In einem solchen Taster entstehen außerdem erheblich verkürzte Leerwege. Weiterhin entsteht ein besonders kompakter Taster, der in eine Vielzahl von Schaltgeräten eingebaut werden kann. Im Mindestfall können mit einem solchen Taster daher drei Signale erzeugt werden.

Nach weiteren Merkmalen ist vorgesehen, daß zur Wegaufnahme zwischen dem ersten Kontakt und dem Folgekontakt mittels eines Hall-Sensors die Veränderung eines Magnetfeldes bei Annäherung eines Permanent-Magneten an den Hall-Sensor meßbar ist. Dadurch können eine berührungslose Messung, ein absolutes Meßsignal und eine einfache und kostengünstige Mechanik erzielt werden.

Das dritte Signal entsteht dadurch, daß bei gemeinsam gedrückten äußeren Stößeln ein zusätzliches Signal unterscheidbar gemacht ist.

Die Modifikation der Erfindung, d.h. die Umsetzung in andere praktische Anwendungsfälle ist besonders leicht durchführbar, indem auf einer drehbar gelagerten Polygonwelle zumindest zwei Permanent-Magnete auf dem Umfang versetzt angeordnet sind und daß dem Umfang ein Hall-Sensor unmittelbar gegenüberliegend zugeordnet ist.

Hierbei ist weiter vorteilhaft, daß auf der Polygonwelle ein Doppelarmhebel befestigt ist, dessen Hebelarme mit den beiden Stößeln zusammenwirken. Der Doppelarmhebel ist als Wippe ausführbar, wobei über die Polygonwelle der Antrieb übertragen wird und eine Rückstellung durch die gefederten Kontaktelemente eines oder mehrerer Tast-Schaltelemente erfolgt.

Eine Ausgestaltung der Erfindung sieht vor, daß die Polygonwelle im Gehäuse drehbar gelagert ist und mit den Stößeln zusammenwirkt und daß auf der Polygonwelle ein Element angeordnet ist, das mit einem ortsfesten Sensor zusammenwirkt. Hier kann demzufolge über die Drehung der Polygonwelle das Tastsignal erzeugt werden, wobei ebenfalls bei zwei Drehrichtungen auch zwei Bewegungsrichtungen eines Antriebs stufenlos schaltbar sind.

Es ist auch hier günstig, daß das Element auf der Pölygonwelle ein Permanent-Magnet ist und daß der Sensor aus dem Hall-Sensor besteht.

Eine vorteilhafte Weiterentwicklung in Form einer Anwendung besteht darin, daß die Stößel, die Polygonwelle und der Hall-Sensor in einem zu einem Griff geformten Gehäuse untergebracht sind. Damit ist der Einsatz des Tasters als integrierter Bauteil in einem Schalter, wie z.B. in einem Hängeschalter, möglich.

Die Betätigung des Tasters kann nach weiteren Merkmalen dadurch erfolgen, daß in Ausnehmungen des Gehäuse-Griffs Schwenkflügel drehbar gelagert sind, die mit ihren Wellen an die Polygonwelle angeschlossen sind. Mit diesen Schwenkflügeln können Signale in beiden Drehrichtungen erzeugt werden.

Ausführungsbeispiele der Erfindung sind in der Zeichnung dargestellt und werden im folgenden näher beschrieben. Es zeigen
- Fig. 1: einen senkrechten Schnitt durch eine erste Ausführungsform des Tasters,
- Fig. 2: eine perspektivische Ansicht einer zweiten Ausführungsform des Tasters und
- Fig. 3: einen Querschnitt durch einen Gehäuse-Griff mit der Tasteranordnung gemäß Fig. 2.

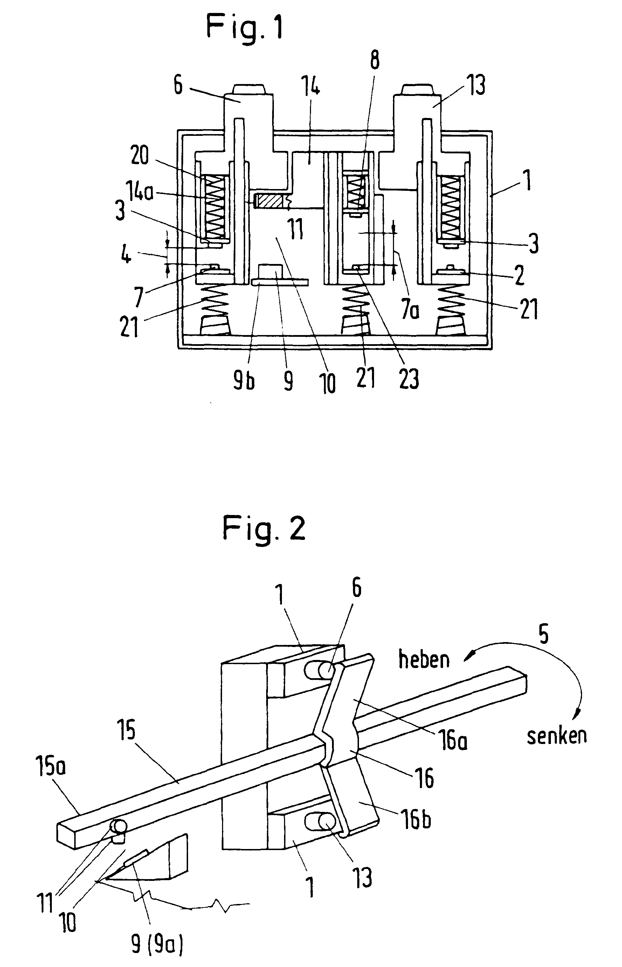

Das Schaltgerät (Taster) - Fig. 1 - besitzt ein Gehäuse 1, das selbst z.B. in das Gehäuse eines Handschalters eingeführt werden kann. Es sind Stößel 6,13,14 mit Rückstellfedern 21 und Kontaktelemente 3,7,8 vorgesehen, die aus den im Stößel 6,13,14 federnd geführten beweglichen Kontakten 3 und 8 und den feststehend im Gehäuse 1 gelagerten Kontakten 2,7 und 23 gebildet werden. Die Betätigung des Tasters erfolgt über einen ersten Stößel 6 mit einem ersten Kontakt 7.

Auf einem geraden Leerweg 4 (Fig. 1) bzw. einem Bogenleerweg 5 (Fig. 2) des ersten Stößels 6 wird der erste Kontakt 7, der für eine Antriebssteuerung z.B. das Signal "Heben" bedeutet, geschlossen, was ein Abgleich-Signal erzeugt. Der Stößel 6 wird durch die Rückstellfeder 21 in seine Ausgangsstellung zurückgedrückt.

An einem Mittelstößel 14 ist eine Nase 14a angebracht, so daß bei Betätigung des ersten Stößels 6 eine Mitnahme des Mittelstößels 14 erfolgt. Am Ende eines Arbeitsweges 7a wird ein Folgekontakt 8 mit dem festehenden Kontakt 23 geschlossen. Zwischen dem ersten Kontakt 7 und dem Folgekontakt 8 wird ein in seiner Größe vom Weg (bzw. Bogenweg) abhängiges elektrisches Signal für die stufenlose Steuerung erzeugt. Hierbei dient im Ausführungsbeispiel zur Wegaufnahme zwischen dem ersten Kontakt 7 und dem Folgekontakt 8 ein Hall-Sensor 9, der auf einer Leiterkarte 9b gehalten ist. Der Hall-Sensor 9 mißt die Veränderung eines Magnetfeldes 10 bei Annäherung eines Permanentmagneten 11 und liefert eine entsprechend dem Abstand des Permanentmagneten 11 analoges Sollwert- Signal. Bei der anfänglichen Betätigung des ersten Stößels 6 wird zunächst an dem ersten Kontakt 7 umd Umschaltelement 3 der Anfangswert des analogen Signals abgeglichen, d.h. definiert. Gleichzeitig wird eine Reglerfreigabe für die Steuerung gegeben und eine Bewegungsrichtung, wie z.B. "Heben" definiert.

Über die Nase 14a folgt der Mittelstößel 14 der Bewegung des ersten Stößels 6 und löst die Wirkung des Permanent-Magneten 11 - wie vorstehend beschrieben - aus. Die Ausgangsspannung des Hall-Sensors 9 vergrößert sich quadratisch mit kleinerwerdendem Abstand zum Permanent-Magneten 11.

Für den Fall, daß der erste Stößel 6 soweit durchgedrückt wird, bis der Folgekontakt 8 mit dem Kontakt 23 des Mittelstößels 14 schließt, erfolgt der Abgleich für den Endwert des analogen Ausgangssignals bzw. Steuersignals.

Für Antriebe mit zwei oder mehr Bewegungsrichtungen ist der erste Stößel 6 für eine erste Bewegungsrichtung und ein zweiter Stößel 13 für eine zweite Bewegungsrichtung vorgesehen. Demgegenüber kann der Mittelstößel 14 zwangsweise zusammen mit einem oder beiden anderen Stößeln 6, 13 betätigt werden. Bei gemeinsam gedrückten äußeren Stößeln 6 und 13 (Fig. 1) wird ein zusätzliches Signal unterscheidbar gemacht, so daß dadurch eine weitere Funktion geschaffen ist.

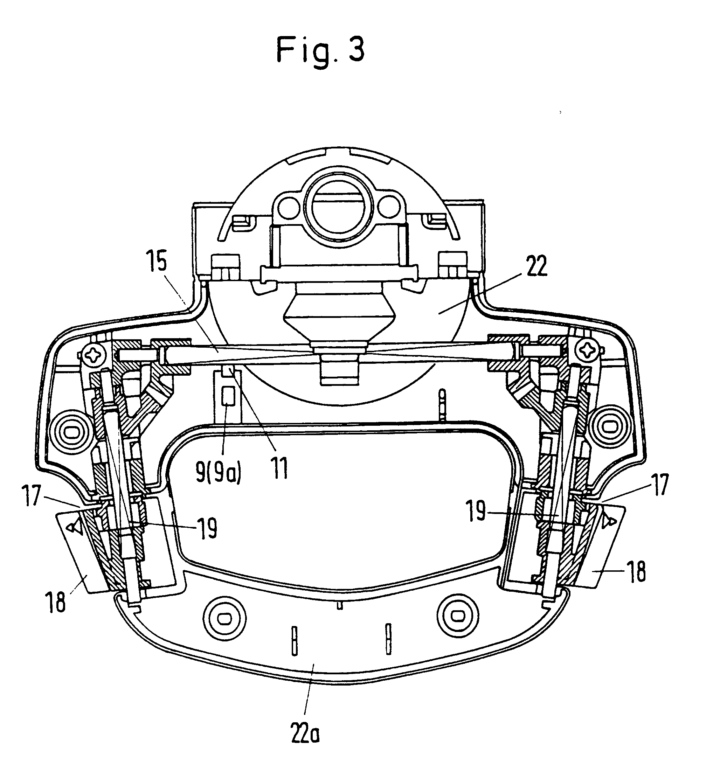

Für einen Wippenbetrieb dient die Ausführungsform gemäß Fig. 2. Die Betätigung der Stößel 6 bzw. 13 erfolgt über die Polygonwelle 15 und über einen als Schaltwippe ausgeführten Doppelarmhebel 16. Hier dient als praktisches Anwendungsbeispiel die Lösung gemäß einer Kombination aus den Fig. 2 und 3. Auf der drehbar gelagerten Polygonwelle 15 sind z.B. zwei Permanent-Magnete 11 am Umfang 15a jeweils an einer Polygonfläche, am Umfang z.B. un 90 Grad versetzt, angeordnet und an dem Umfang 15a ist der Hall-Sensor 9 unmittelbar gegenüberliegend zugeordnet, so daß ein Magnetfeld 10 wie gemäß Fig. 1 entsteht. Auf der Polygonwelle 15 ist in der Art eines Wipphebels ein Doppelarmhebel 16 befestigt, dessen Hebelarme 16a und 16b mit den beiden Stößeln 6 und 13 zusammenarbeiten. Eine solche Baugruppe ist gemäß Fig. 3 in dem Gehäuse 1 integriert. Die Polygonwelle 15 ist in einem Schaltergehäuse 22 drehgelagert und arbeitet mit den Stößeln 6 und 13 wie beschrieben zusammen. Auf der Polygonwelle 15 ist ein Element (z.B. ein Permanent-Magnet 11) angeordnet, das mit einem relativ ortsfesten Sensor 9a (dem Hall-Sensor 9) zusammenwirkt. Die Stößel 6, 13 und 14, die Polygonwelle 15 und der Hall-Sensor 9 sind in dem zu einem Griff 22a geformten Schaltergehäuse 22 untergebracht, d.h. der Taster ist in dem Schaltergehäuse 22 integriert. Dabei sind in Ausnehmungen 17 des Gehäuse-Griffs 22a Schwenkflügel 18 drehbar gelagert, die mit ihren Wellen 19 an die Polygonwelle 15 angeschlossen sind. Auf die Polygonwelle 15 sind die beiden Permanent-Magnete 11 so aufgebracht, daß sie untereinander einen Winkel von 90 Grad bilden. Der Hall-Sensor 9 ist dabei so befestigt, daß jeder Permanent-Magnet 11 in der Ruhestellung zu ihm die gleiche Entfernung hat. Für den Fall, daß nun die Schwenkflügel 18 betätigt werden, dreht sich die Polygonwelle 15 und somit die Permanent-Magnete 11 über den Hall-Sensor 9. Dieser verändert nun sein Ausgangssignal in Abhängigkeit der Entfernung bzw. des Drehwinkels der Permanent-Magnete 11. Das Schaltgerät ist mit seinem ersten Stößel 6 und dem zweiten Stößel 13 wie zu Fig. 1 beschrieben ausgeführt, jedoch ist der Hall-Sensor 9 mit dem zugehörigen Permanent-Magneten 11 wie in Fig. 3 ersichtlich außerhalb des Gehäuses 1 angeordnet Der jeweils betätigte Stößel 6 bzw. 13 gibt das Analogsignal frei und eine Drehrichtung vor. Mit dem Schließen des Kontaktes wird der Analogwert abgeglichen, so daß eine symmetrische Sollwertvorgabe erfolgen kann. Für den Fall, daß der Schwenkflügel 18 losgelassen wird, öffnet der Tasterkontakt, und die Rückstellfeder 21 des ersten Stößels 6 bzw. des zweiten Stößels 13 drückt die Polygonwelle 15 mit den Permanent-Magneten 11 in ihre Ausgangsposition zurück.

### Bezugszeichenliste

- 1: Gehäuse
- 2: Kontakte
- 3: gefedertes Kontaktelement
- 4: gerader Leerweg
- 5: Bogenleerweg
- 6: erster Stößel
- 7: erster Kontakt
- 7a: Arbeitswe bzw. Folgeweg
- 8: Folgekontakt
- 9: Hall-Sensor
- 9a: Sensor
- 9b: Leiterkarte
- 10: Magnetfeld
- 11: Permanent-Magnet
- 12: zweiter Kontakt
- 13: zweiter Stößel
- 14: Mittelstößel
- 14a: Nase
- 15: Polygonwelle
- 15a: Umfang
- 16: Doppelarmhebel
- 16a: Hebelarm
- 16b: Hebelarm
- 17: Ausnehmung
- 18: Schwenkflügel
- 19: Welle
- 20: Feder
- 21: Rückstellfeder
- 22: Schaltergehäuse
- 22a: Griff
- 23: festehender Kontakt

## Patentansprüche

1. Schaltgerät für Handbetätigung und die Umwandlung eines Betätigungsweges in ein elektrisches Signal in Verbindung mit einer stufenlosen Steuerung für fördertechnische Antriebe, Fahrantriebe, Hubantriebe, Kettenzüge und Schwenkantriebe, mit zwei oder mehr Bewegungsrichtungen, mit einem Gehäuse (1) für die Bildung von Schaltkontakten mittels gefederter Kontaktelemente, wobei Mittel vorgesehen sind, so daß auf einen geraden Leerweg (4) eines Stößels (6) folgend ein erste, Kontakt (7; 3) und am Ende eines Arbeitsweges (7a) ein Folgekontakt (B) schließbar sind, so daß dann der erste und der Folgekontakt (B) geschlossen sind, wobei Mittel vorgesehen sind, durch die zwischen dem ersten Kontakt (7; 3) und dem Folgekontakt (B) ein in der Größe vom Folgeweg abhängiges elektrisches Signal für die stufenlose Steuerung erzeugbar ist,
dadurch gekennzeichnet,
daß ein erster Stößel (6) für eine erste Bewegungsrichtung und ein zweiter Stößel (13) für eine zweite Bewegungsrichtung vorgesehen sind und daß zwischen dem ersten und dem zweiten Stößel (6; 13) ein gemeinsam betätigbarer Mittelstößel (14) für den Folgekontakt (8) angeordnet ist und
daß der Mittelstößel (14) für den Folgekontakt (8) jeweils in Abhängigkeit eines der beiden außen angeordneten ersten und zweiten Stößel (6; 13) zwangsweise betätigbar ist.

2. Schaltgerät nach Anspruch 1,
dadurch gekennzeichnet,
daß zur Wegaufnahme zwischen dem ersten Kontakt (7) und dem Folgekontakt (8)mittels eines Hall-Sensors (9) die Veränderung eines Magnetfeldes (10) bei Annäherung eines Permanent-Magneten (11) an den Hall-Sensor (9) meßbar ist.

3. Schaltgerät nach einem der Ansprüche 1 bis 2
dadurch gekennzeichnet,
daß bei gemeinsam gedrückten äußeren Stößeln (6; 13) ein zusätzliches Signal unterscheidbar gemächt ist.

4. Schaltgerät nach einem der Ansprüche 1 bis 3
dadurch gekennzeichnet,
daß auf einer drehbar gelagerten Polygonwelle (15) ein Doppelarmhebel (16) befestigt ist, dessen Hebelarme (16a, 16b) mit den beiden Stößeln (6; 13) zusammenwirken.

5. Schaltgerät nach Anspruch 4,
dadurch gekennzeichnet,
daß auf der Polygonwelle (15) zumindest zwei Permanent-Magnete (11) am Umfang (15a) versetzt angeordnet sind und daß dem Umfang (15a) ein Hall-Sensor (9) ortsfest unmittelbar gegenüberliegend zugeordnet ist.

6. Schaltgerät nach Anspruch 4 oder 5,
dadurch gekennzeichnet,
daß die Stößel (6; 13; 14), die Polygonwelle (15) und der Hall-Sensor (9) in einem zu einem Griff (22a) geformten Gehäuse (1) untergebracht sind.

7. Schaltgerät nach Anspruch 6,
dadurch gekennzeichnet,
daß in Ausnehmungen (17) des Gehäuse-Griffs (22a) Schwenkflügel (18) drehbar gelagert sind, die. mit ihren Wellen (19) an die Polygonwelle (15) angeschlossen sind.

## Revendications

1. Appareil de commutation destiné à la commande manuelle et à la conversion d'une course de commande en un signal électrique, en liaison avec une commande continue destinée à des entraînements en matière de technique de transport, des entraînements de marche, des entraînements de levage, des palans à chaînes, et des entraînements de pivotement à deux ou plus directions de déplacement, comportant un boîtier (1) pour la formation de contacts de commutation au moyen d'éléments de contact élastiques, des moyens étant prévus afin qu'un premier contact (7 ; 3) puisse être fermé en suivant une course à vide rectiligne (4) d'un poussoir (6), et qu'un contact consécutif (8) puisse être fermé à la fin d'une course de travail (7a), de sorte que le premier contact et le contact consécutif (8) soient alors fermés, des moyens étant prévus par lesquels un signal électrique destiné à la commande continue peut être engendré entre le premier contact (7 ; 3) et le contact consécutif (8) en fonction de l'importance de la course consécutive,
caractérisé en ce qu'un premier poussoir (6) est prévu pour une première direction de déplacement et un deuxième poussoir (13) est prévu pour une deuxième direction de déplacement, et en ce qu'un poussoir central (14) pouvant être commandé en commun est disposé pour le contact consécutif (8) entre les premier et deuxième poussoirs (6 ;13) et en ce que le poussoir central (14) pour le contact consécutif (8) peut être actionné par une commande forcée en fonction de l'un des deux premier et deuxième poussoirs (6 ; 13) disposés à l'extérieur.

2. Appareil de commutation selon la revendication 1,
caractérisé en ce que, pour détecter la course entre le premier contact (7) et le contact consécutif (8) au moyen d'un détecteur à effet Hall (9), la modification d'un champ magnétique (10) peut être mesurée lorsqu'un aimant permanent (11) s'approche du détecteur à effet Hall (9).

3. Appareil de commutation selon une des revendications 1 à 2,
caractérisé en ce qu'un signal supplémentaire est rendu discernable lorsque les deux poussoirs externes (6 ; 13) sont enfoncés simultanément.

4. Appareil de commutation selon une des revendications 1 à 3,
caractérisé en ce qu'un levier (16) à double bras est fixé sur un arbre polygonal (15) monté en rotation, dont les bras de levier (16a, 16b) agissent conjointement avec les deux poussoirs (6 ; 13).

5. Appareil de commutation selon la revendication 4,
caractérisé en ce qu'au moins deux aimants permanents (11) sont disposés en étant décalés sur la périphérie (15a) de l'arbre polygonal (15), et en ce qu'un détecteur à effet Hall (9) situé directement en face est associé à demeure à la périphérie (15a).

6. Appareil de commutation selon la revendication 4 ou 5,
caractérisé en ce que les poussoirs (6 ; 13 ; 14), l'arbre polygonal (15), et le détecteur à effet Hall (9) sont logés dans un boîtier (1) en forme de poignée (22a).

7. Appareil de commutation selon la revendication 6,
caractérisé en ce que des volets pivotants (18) sont montés en rotation dans des évidements (17) de la poignée (22a) formant boîtier, qui sont raccordés à l'arbre polygonal (15) par leurs arbres (19).

## Claims

1. Switchgear for manual operation and converting an operating travel into an electrical signal in conjunction with a continuous control for conveying drives, traversing drives, lifting drives, chain hoists and pivot drives, with two or more directions of movement, with a housing (1) for forming switching contacts by means of spring-loaded contact elements, wherein means are provided so that a first contact (7; 3) can be closed following a straight pre-travel (4) of a plunger (6), and a follow-up contact (8) can be closed at the end of an operating travel (7a), so that the first contact and the follow-up contact (8) are then closed, wherein means are provided via which an electrical signal which is dependent in magnitude on the follow-up travel can be generated for the continuous control between the first contact (7; 3) and the follow-up contact (8), characterised in that a first plunger (6) is provided for a first direction of movement and a second plunger (13) for a second direction of movement, and that a central plunger (14), which can be operated in concert, for the follow-up contact (8) is disposed between the first and the second plunger (6; 13), and that the central plunger (14) for the follow-up contact (8) can in each case be operated forcibly dependent upon one of the two externally disposed first and second plungers (6; 13).

2. Switchgear according to Claim 1, characterised in that a Hall effect sensor (9) can measure the change in a magnetic field (10) when the Hall effect sensor (9) is approached by a permanent magnet (11) for travel detection between the first contact (7) and the follow-up contact (8).

3. Switchgear according to either of Claims 1 and 2, characterised in that an additional signal is rendered distinguishable when the external plungers (6; 13) are depressed together.

4. Switchgear according to any one of Claims 1 to 3, characterised in that a two-armed lever (16) is secured to a rotatably mounted polygonal shaft (15), the lever arms (16a, 16b) of which lever co-operate with the two plungers (6; 13).

5. Switchgear according to Claim 4, characterised in that at least two permanent magnets (11) are disposed in a staggered manner at the circumference (15a) of the polygonal shaft (15), and that a Hall effect sensor (9) is associated with the circumference (15a) such that it lies directly opposite in a stationary manner.

6. Switchgear according to Claim 4 or 5, characterised in that the plungers (6; 13; 14), the polygonal shaft (15) and the Hall effect sensor (9) are accommodated in a housing (1) shaped into a handle (22a).

7. Switchgear according to Claim 6, characterised in that pivot vanes (18) are rotatably mounted in recesses (17) in the housing handle (22a) and connected to the polygonal shaft (15) by their shafts (19).
